Europäisches Patentamt

European Patent Office

Office européen des brevets

(11) Numéro de publication: **0 011 025**
**A1**

# DEMANDE DE BREVET EUROPEEN

(21) Numéro de dépôt: **79400790.6**

(22) Date de dépôt: **24.10.79**

(51) Int. Cl.³: **G 11 B 31/00,** G 11 B 25/06, H 05 K 7/02, G 11 B 1/00

(30) Priorité: **24.10.78 FR 7830139**

(43) Date de publication de la demande: **14.05.80**
**Bulletin 80/10**

(84) Etats contractants désignés: **BE CH DE GB IT NL SE**

(71) Demandeur: **RENT MUSIC (Sarl française), 5, rue Agar, F-75016 Paris (FR)**

(72) Inventeur: **Fedoroff, Michel, F-60390 Malassise (FR)**

(74) Mandataire: **Cuer, André, CABINET CUER 30, rue de Léningrad, F-75008 Paris (FR)**

(54) **Appareil de reproduction des sons à modules interchangeables.**

(57) L'appareil selon l'invention comporte un boîtier de base muni de son ensemble électronique destiné à préamplifier ou amplifier des sources de modulation différentes et dans lequel sont prévues une ou plusieurs cases destinées à recevoir des tiroirs ou modules amovibles à éléments purement mécaniques, interchangeables et remplissant une fonction donnée telle que par exemple: lecture de bande de cartouche ou cassette, diffusion intermittente de messages (publicité ou autre), etc . . .

L'intervertion des modules et le remplacement d'un module défectueux sont instantanés et procurent une grande souplesse ainsi qu'une sensible économie à l'utilisateur.

Appareil de reproduction des sons à
modules interchangeables

La présente invention a trait au domaine des appareils et dispositifs de reproduction ou diffusion sonore et concerne plus spécialement des coffrets, munis d'organes électroniques et mécaniques, aptes à remplir des fonctions multiples incluant la lecture de bandes sonores, du type paroles ou musique, l'écoute de radio et opérations similaires.

Dans des appareils de diffusion sonore connus à ce jour, qu'il s'agisse de postes de radio, de lecteurs de cassettes ou de cartouches ou systèmes analogues, la partie mécanique et l'ensemble électronique sont disposés en coopération au sein d'un même boîtier de sorte que chaque appareil est monobloc. Grâce aux rapides et spectaculaires progrès réalisés dans le domaine de l'électronique, il est extrêmement rare que des pannes proviennent du système électronique alors que, dans la partie mécanique, les éléments souffrent fréquemment de défectuosités et ont une durée de vie nettement plus limitée. Lorsque de tels appareils ne fonctionnent plus correctement, il faut faire appel au dépanneur ou réparateur qui, le plus souvent, doit procéder au démontage du boîtier puis, après des séries de tests pour effectuer un diagnostic, doit mettre en pièces l'ensemble mécanique en vue de changer les éléments usés ou cassés. Parfois, lorsque l'appareil est sous garantie et qu'il a été acheté loin de son lieu d'utilisation, il est nécessaire de l'expédier et, outre les risques que cela comporte, de supporter de longs délais d'attente.

On a déjà préconisé, certes, l'insertion de boîtiers amovibles, par exemple pour l'enregistrement de sons, dans un coffret général apte à remplir plusieurs fonctions (voir par exemple brevet français n° 1.146.793 du 13 février 1956 ; brevet allemand n° 1.472.015 du 15 mai 1965). Toutefois, ces boîtiers qui s'enclenchent dans le réceptacle d'ensemble sont composés à la fois de parties électriques ou électroniques et de parties mécaniques et l'on ne peut ainsi résoudre le problème posé ci-dessus de remplacement rapide et peu coûteux du seul ensemble mécanique, objet de fréquentes pannes.

L'invention a pour but d'obvier à la série d'inconvénients précités et de proposer une solution rationnelle et d'utilisation commode pour résoudre ce problème technique de la fréquente remise en état des éléments mécaniques dans les dispositifs des types précités. Elle offre à cet effet un appareil dans lequel un boîtier de base, muni de son ensemble électromécanique classique, peut recevoir à volonté des éléments préfabriqués susceptibles d'être changés instantanément en cas de panne et procurant une large gamme de programmes de reproduction de sons, paroles ou musiques.

Le nouvel appareil selon l'invention est basé sur le principe d'un coffret ou boîtier contenant une électronique destinée à pré-amplifier ou amplifier des sources de modulation différentes, ce coffret étant muni d'au moins une case pouvant recevoir un module ou tiroir amovible contenant essentiellement des éléments mécaniques et apte à être enclenché directement et instantanément dans le coffret.

Ainsi, en cas de défectuosité ou usure des parties mécaniques, les plus vulnérables, de son dispositif de reproduction des sons, l'utilisateur peut dégager immédiatement du boîtier le tiroir responsable de la panne et procéder lui-même à son remplacement par un tiroir neuf ou rénové.

En pratique, bien que l'invention inclut un dispositif de type "rack" à un seul module, par exemple lecteur de bandes ou radio, il est particulièrement avantageux, vu les multiples possibilités offertes, de prévoir un coffret capable de recevoir n modules correspondant à n cases (par exemple deux, trois ou plus), ces modules étant interchangeables et pouvant chacun remplir une fonction donnée, comme par exemple : lecteur de bandes enregistrées en cartouches à multipistes ou en cassettes ; tuner-radio à sélection d'ondes ; diffusion intermittente, par système de minuterie, de messages parlés ou d'indicatifs pré-enregistrés (publicité ou autre)... etc.

L'invention sera mieux comprise par la description d'un mode de réalisation, non limitatif, en référence aux dessins schématiques annexés qui illustrent le principe de base de l'innovation en cause et où l'on peut voir :

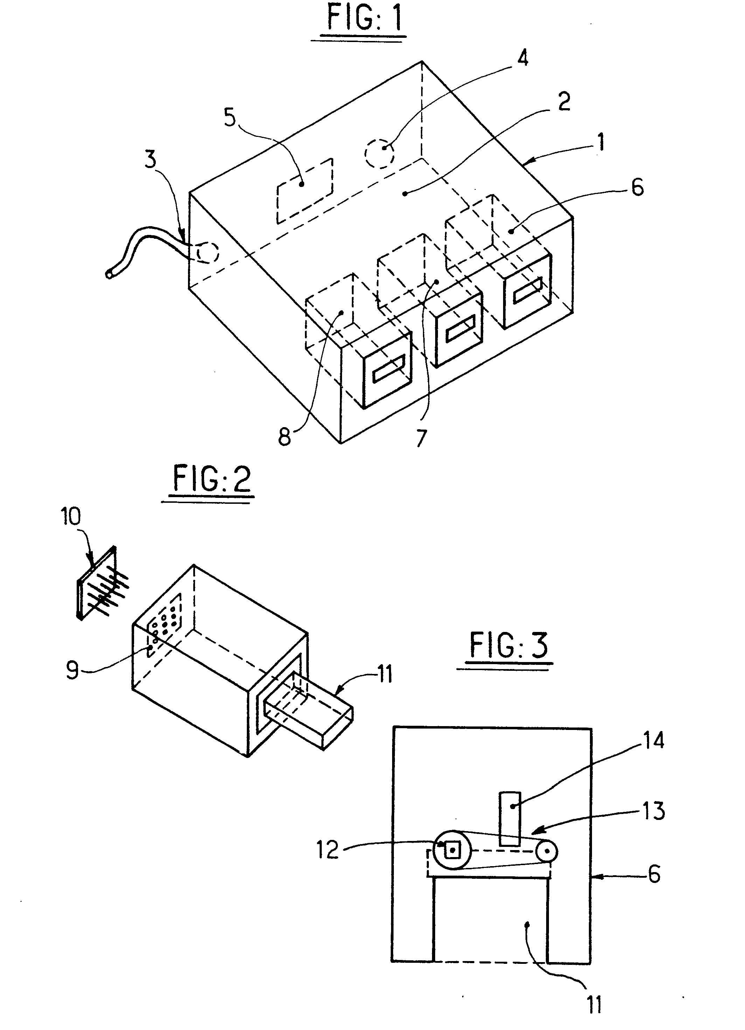

. Figure 1, un boîtier ou coffret équipé de plusieurs modules amovibles et interchangeables ;

. Figure 2, l'un des modules ou tiroirs muni de son système d'enclenchement

. Figure 3, une vue en plan très schématique et simplifiée de l'intérieur d'un module donné du type lecteur de bandes.

Un appareil de l'invention se présente donc sous la forme d'un coffret 1, équipé de son ensemble électronique en 2 (non représenté car ne faisant pas partie de l'invention) et muni de son alimentation en courant 3 ainsi que, par exemple d'autres organes tels que : sortie 4 pour haut-parleurs lorsque le boîtier renferme un amplificateur, relais 5 pour amplificateur extérieur lorsqu'un pré-amplificateur est prévu dans le coffret ...

Selon la caractéristique de l'invention, le coffret 1 comporte un ou des espaces libres (par exemple trois sur la figure 1) servant de logements à des modules ou tiroirs 6, 7, 8 lesquels sont engagés au sein du boîtier dans des glissières ou moyens analogues et sont verrouillés, après positionnement, par un doigt ou système d'accrochage équivalent prévu par exemple sur la face interne inférieure ou supérieure du boîtier (éléments non représentés sur les figures).

Chaque module, amovible, est mis instantanément en fonctionnement grâce à la coopération d'une prise femelle 9 adaptée à l'arrière et d'une broche 10 solidaire du boîtier et commandant la liaison électronique avec l'ensemble mécanique du module.

Comme dit ci-dessus, un module remplit une fonction donnée et le coffret est prévu pour que les n modules qu'il peut recevoir soient interchangeables ; par exemple un module ou tiroir 6 destiné à la lecture de cartouches 11 peut être interverti avec son module adjacent 7 qui peut être un lecteur de minicassettes ou encore avec le module 8, qui peut être un diffuseur de messages publicitaires pré-enregistrés. Ceci, bien entendu, à titre non limitatif.

Les modules amovibles selon l'invention renferment la partie purement mécanique, la plus vulnérable, de l'appareil de reproduction sonore. Par exemple, pour un module de type lecteur de bandes, cette partie comporte essentiellement (voir figure 3) un moteur 12, un dispositif 13 d'entraînement de la bande et une tête de lecture 14.

L'intérêt d'appareils conformes à l'invention n'échappera pas à l'utilisateur : en effet, d'une part il suffit à celui-ci de posséder un seul boîtier ou coffret de base avec une sélection, selon son gré, des sources de reproduction souhaitées (nombre et types de modules) et, d'autre part, cet usager peut lui-même changer instantanément le module défectueux ainsi

4

0011025

qu'intervertir la position des modules selon le nombre de cases de son boîtier porteur. Grâce au très grand nombre de combinaisons possibles, il devient facile et économique de créer une véritable régie sonore ou de compléter une installation existante.

REVENDICATIONS

1. Appareil de reproduction et/ou d'enregistrement des sons du type coffret ou boîtier muni de ses ensembles connus mécaniques et électroniques, caractérisé en ce que le coffret comporte uniquement les éléments d'électronique et est muni d'au moins une case destinée à recevoir un module amovible comprenant les éléments mécaniques et apte à être enclenché directement et instantanément dans le coffret.

2. Appareil selon la revendication 1, caractérisé en ce que le coffret peut recevoir n modules correspondant à n cases, ces modules étant interchangeables et pouvant chacun remplir l'une des fonctions choisies dans le groupe : lecture de bandes enregistées en cartouches à multipistes ou en cassettes ; tuner-radio avec possibilité de sélection de diverses ondes ; diffusion intermittente, par système de minuterie, de messages parlés ou d'indicatifs pré-enregistrés.

3. Appareil selon l'une quelconque des revendications 1 ou 2, caractérisé en ce que chaque case du coffret est munie de glissières latérales dans lesquelles s'engagent les arêtes du module (ou tiroir), généralement de forme parallélipédique, un système de verrouillage étant en outre prévu dans le boîtier pour bloquer le module pendant sa position de fonctionnement.

4. Appareil selon l'une quelconque des revendications 1 à 3, caractérisé en ce que l'enclenchement d'un module dans le boîtier, qui procure une mise en fonctionnement instantanée, est réalisé par la coopération d'une broche mâle solidaire du boîtier et d'une prise femelle installée à l'arrière du module.

0011025

## FIG: 1

## FIG: 2

## FIG: 3

Office européen
des brevets

**RAPPORT DE RECHERCHE EUROPEENNE**

0011025

Numero de la demande

EP 79 40 0790

| Catégorie | Citation du document avec indication, en cas de besoin, des parties pertinentes | Revendica-tion concernee |
|---|---|---|
| | FR - A - 1 146 793 (MARSAN)  <br> * Résumé; figures 1-3 * | 1,2,4 |
| | DE - A - 1 472 015 (LOEWE-OPTA)  <br> * Page 4, ligne 10 à page 5; figures 2,3 * | 1,3,4 |
| | FR - A - 2 310 665 (TOUREY)  <br> * Page 2, ligne 26 à page 3, ligne 21; figures * | 1-4 |
| | FR - A - 2 103 674 (ZEISS IKON)  <br> * Revendications 1-3; figures * | 1,3 |
| | FR - A - 2 046 084 (BOSCH)  <br> * Page 6, lignes 3-18; figures 7,8 * | 1-4 |
| A | DE - A - 2 015 376 (SUD-ATLAS)  <br> * Revendications; figures * | 1,4 |
| A | DE - A - 2 009 824 (SUD-ATLAS)  <br> * Revendications; figures * | 1,4 |

## DOCUMENTS CONSIDERES COMME PERTINENTS

**CLASSEMENT DE LA DEMANDE (Int. Cl.**

G 11 B 31/00,
25/00
H 05 K 7/00
G 11 B 1/00

**DOMAINES TECHNIQUES RECHERCHES (Int. Cl.**

G 11 B 31
25
1
15
H 05 K 5
7

**CATEGORIE DES DOCUMENTS CITES**

X: particulièrement pertinent
A: arrière-plan technologique
O: divulgation non-ecrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achevement de la recherche | Examinateur |
|---|---|---|
| La Haye | 30-01-1980 | DECLAT |

OEB Form 1503.1   06.78